# EUROPÄISCHE PATENTSCHRIFT

(11) **EP 2 744 309 B1**
(45) Veröffentlichungstag und Bekanntmachung des Hinweises auf die Patenterteilung: **15.02.2017**
(21) Anmeldenummer: 12196648.5
(22) Anmeldetag: 12.12.2012
(51) Int. Cl.: H05K 1/05, H05K 1/02, G01D 11/24, H05K 3/00

(54) **Elektrisches Verbindungselement**
Electric connecting element
Elément de liaison électrique

(43) Veröffentlichungstag der Anmeldung: 18.06.2014
(73) Patentinhaber: SICK AG, 79183 Waldkirch/Breisgau (DE)
(72) Erfinder: Seemann, Ehrenfried, 79183 Waldkirch-Siensbach (DE)
(74) Vertreter: Manitz, Finsterwald & Partner GbR

(56) Entgegenhaltungen:
- DE-A1- 19 720 167
- DE-A1-102010 025 591
- DE-B3-102004 053 958
- GB-A- 2 484 152
- KR-B1- 100 885 197

## Beschreibung

Die vorliegende Erfindung betrifft ein elektrisches Verbindungselement zum Verbinden von Komponenten eines optoelektronischen Sensors.

Optoelektronische Sensoren wie zum Beispiel Lichtschranken oder Lichttaster weisen üblicherweise ein Gehäuse auf, in welchem mehrere Komponenten wie Sender, Empfänger, Betätigungsknöpfe, Anzeigeleuchten und dergleichen untergebracht sind. Diese Komponenten müssen innerhalb des Gehäuses untereinander und/oder mit einer zugehörigen zentralen Steuereinrichtung elektrisch verbunden werden. Dies kann beispielsweise mittels einer Leiterplatte erfolgen, auf welcher Kontaktstellen für die jeweiligen Komponenten sowie erforderlichenfalls für eine zentrale Steuereinrichtung vorgesehen sind.

Problematisch ist hierbei, dass eine solche Leiterplatte nur für eine bestimmte Gehäuseform und -größe sowie für eine bestimmte Anordnung der jeweiligen Komponenten passend ist. Ein Hersteller von unterschiedlichen optoelektronischen Sensoren muss daher für jeden einzelnen Sensortyp eine eigene Leiterplatte entwickeln, was mit vergleichsweise hohen Herstellungskosten verbunden ist.

Grundsätzlich wäre es auch möglich, die Komponenten in dem Gehäuse einzeln mittels flexibler Kabelleitungen zu verbinden. Diese Vorgehensweise ist jedoch aufwändig und kostspielig.

Die DE 10 2004 053 958 B3 offenbart einen Sonnensensor, bei welchem mehrere Fotodioden auf einer verformbaren Metallkernleiterplatte aufgebracht sind. Die Platte weist eine Kupferschicht mit darauf aufgebrachten Isolierschichten auf, auf welchen wiederum die Leiterbahnen angeordnet sind.

In der GB 24 84 152 A1 ist eine elektrische Leuchte offenbart, die auf einem LED-Array beruht. Die LEDs sind auf einen flachen Träger aus Aluminiumblech aufgebracht, welcher mit einer Isolierschicht und entsprechenden Leiterbahnen versehen ist.

Die KR 100885197 B1 offenbart eine Anordnung von LEDs, welche auf eine dünne Trägerplatte aufgebracht sind.

Der in der DE 10 2010 025 591 A1 offenbarte Sensor weist eine Trägerplatte aus Kunststoff oder Metall auf, von welcher mehrere Streifen abstehen.

Die DE 197 20 167 A1 offenbart eine flexible Leiterplatte zum Anschließen von Sensoren, Aktoren und Steckern an die Zentraleinheit einer Getriebesteuerung.

Es ist eine Aufgabe der Erfindung, mit einfachen Mitteln bei unterschiedlichen Vorrichtungen ein elektrisches Verbinden der vorhandenen Komponenten zu ermöglichen.

Die Lösung der Aufgabe erfolgt durch ein elektrisches Verbindungselement mit den Merkmalen des Anspruchs 1.

Ein erfindungsgemäßes elektrisches Verbindungselement umfasst einen flächigen Leitungskörper, welcher wenigstens einen streifenförmigen Leitungsarm aufweist, wobei der streifenförmige Leitungsarm eine elektrisch isolierende Beschichtung aufweist, auf welcher wenigstens eine sich zwischen zwei Kontaktstellen erstreckende Leiterbahn aufgebracht ist, wobei der Leitungskörper aus Blech gefertigt ist und die Leiterbahn durch die elektrisch isolierende Beschichtung elektrisch von dem streifenförmigen Leitungsarm getrennt ist. Die zu verbindenden Komponenten können über die Kontaktstellen an die Leiterbahn angeschlossen werden, so dass sich eine zuverlässige elektrische Verbindung zwischen den Komponenten ergibt. Der Vorteil eines aus Blech gefertigten Leitungskörpers besteht insbesondere darin, dass ein Blechkörper eigensteif, abkantbar und leicht durchtrennbar ist. Somit kann zum Beispiel durch einfaches Knicken und Abschneiden des streifenförmigen Leitungsarms das Verbindungselement an ein bestimmtes Sensorgehäuse angepasst, also vorgeformt werden. Das Vorformen kann hierbei durch entsprechendes Abknicken und Zurechtbiegen des Leitungskörpers nicht nur innerhalb einer Ebene, sondern räumlich erfolgen, wodurch sich eine besonders hohe Vielseitigkeit hinsichtlich der Gestaltung des Verbindungselements ergibt. Somit kann die elektrische Verbindung der vorhandenen Komponenten in unterschiedlichen Sensoren auf Basis einer einheitlichen Gleichteilplattform erfolgen, wodurch sich die Entwicklungs- und Herstellungskosten bei der Fertigung optoelektronischer Sensoren beträchtlich verringern lassen.

Erfindungsgemäß ist außerdem vorgesehen, dass der wenigstens eine streifenförmige Leitungsarm in mehrere durch Zwischenräume voneinander getrennte, insbesondere parallel verlaufende Einzelstreifen unterteilt ist, wobei auf jeden Einzelstreifen eine Leiterbahn aufgebracht ist. Aufgrund der Zwischenräume sind die einzelnen Leiterbahnen elektrisch voneinander isoliert. Die Zwischenräume können durch einen einfachen Stanzvorgang erstellt werden.

Die Einzelstreifen sind hierbei an wenigstens einer Stützstelle und bevorzugt an mehreren Stützstellen durch Abstandhalter zusammengehalten. Solche Abstandhalter können beispielsweise aus einem Kunststoff bestehen. Vorzugsweise werden die Abstandhalter nachträglich in die Zwischenräume eingegossen. Die Stabilität des Leitungsarms kann durch derartige Abstandhalter erhöht werden. Durch die zwischen den Abstandhaltern vorhandenen freien Abschnitte paralleler Einzelstreifen wird hingegen die Flexibilität des Leitungskörpers erhöht, was insbesondere beim Kontaktieren, zum Beispiel durch Einstecken, der in dem Gehäuse fest montierten Komponenten hilfreich sein kann.

Weiterbildungen der Erfindung sind in den abhängigen Ansprüchen, der Beschreibung sowie der beigefügten Zeichnung angegeben.

Der Leitungskörper ist vorzugsweise als Stanzteil ausgebildet. Stanzteile aus Blech sind besonders einfach und kostengünstig herstellbar.

Der wenigstens eine streifenförmige Leitungsarm kann wenigstens eine Abwinklung und/oder wenigstens eine Soll-Knickstelle aufweisen. Unter einer Abwinklung ist hierbei ein abgewinkelter Verlauf des Leitungsarms innerhalb der durch den flächigen Leitungskörper definierten Ebene zu verstehen. Demgegenüber ist unter einem Knicken des Leitungsarms ein Biegen oder Abkanten des Leitungsarms um eine in der durch den flächigen Leitungskörper definierten Ebene verlaufende Biege-Achse zu verstehen. Durch solche Abwinklungen bzw. Soll-Knickstellen kann erreicht werden, dass aus einem einheitlichen Grundelement eine Vielzahl von räumlichen Leitungsgebilden herstellbar ist.

Gemäß einer Ausführungsform der Erfindung ist an dem wenigstens einen streifenförmigen Leitungsarm wenigstens eine Markierung vorgesehen, welche eine Soll-Knickstelle und/oder eine Trennstelle des Leitungsarms kenntlich macht. Beispielsweise können als Markierungen gestrichelte Linien vorgesehen sein. Alternativ oder zusätzlich kann die Markierung in den Leitungsarm eingeprägt sein. Dies ist insofern vorteilhaft, als ein Knicken entlang der vorgeprägten Markierung besonders leicht und exakt von Statten geht. Derartige Markierungen erleichtern das Vorformen von individuellen Verbindungselementen anhand einer einheitlichen Gleichteilplattform beträchtlich.

Der Leitungskörper kann auch einen Zentralabschnitt umfassen, von welchem aus sich wenigstens zwei und bevorzugt wenigstens vier streifenförmige Leitungsarme erstrecken. Eine derartige Ausgestaltung unterstützt insbesondere das Verbinden mehrerer elektrischer Komponenten mit einer gemeinsamen Steuereinrichtung. Die wenigstens zwei Leitungsarme können sich ausgehend von dem Zentralabschnitt in unterschiedliche Richtungen erstrecken.

Gemäß einer speziellen Ausgestaltung weist der Leitungskörper in seinem nicht vorgeformten Grundzustand eine sternartige oder spinnenartige Form auf. Durch Abschneiden, Biegen und Knicken der mehreren Leitungsarme kann aus einem solchen Grundkörper eine Vielzahl von unterschiedlichen eigensteifen Verbindungsstrukturen erstellt werden.

An dem Zentralabschnitt kann ein Mikrochip angeordnet sein, welcher mit den Leiterbahnen aller Leitungsarme in elektrischem Kontakt steht. Der Mikrochip kann beispielsweise eine speicherprogrammierbare Steuerung (SPS), eine anwendungsspezifische integrierte Schaltung (ASIC) und/oder einen Mikroprozessor enthalten. Der Mikrochip kann somit eine zentrale Steuerungseinheit des zugehörigen optoelektronischen Sensors bilden, welche mit allen Einzelkomponenten wie Sender, Empfänger, Betätigungsknopf und Anzeigeleuchte verbunden ist.

Die Erfindung betrifft auch ein Verfahren zum Herstellen eines optoelektronischen Sensors, wobei ein Gehäuse für den Sensor bereitgestellt wird und mehrere Komponenten wie Sender, Empfänger und Betätigungsknopf in dem Gehäuse angebracht werden.

Erfindungsgemäß wird ein wie vorstehend beschriebenes Verbindungselement bereitgestellt. Das Verbindungselement wird in Abhängigkeit von der Form und der Größe des Gehäuses sowie von der Lage der Komponenten in dem Gehäuse durch Knicken und/oder Durchtrennen des wenigstens einen streifenförmigen Leitungsarms vorgeformt. Die Komponenten werden dann mittels des vorgeformten Verbindungselements miteinander verbunden. Die elektrische Verbindung der einzelnen Komponenten eines optoelektronischen Sensors kann somit auf Basis einer für eine Vielzahl von Sensortypen gemeinsamen Gleichteilplattform erfolgen, wobei der Prozess des Vorformens lediglich einfache und schnell durchzuführende

Schritte wie das Durchschneiden und/oder das Abkanten eines Blechstreifens erfordert.

Die Erfindung wird nachfolgend beispielhaft unter Bezugnahme auf die Zeichnungen beschrieben.
- Fig. 1: zeigt eine Draufsicht auf ein erfindungsgemäßes elektrisches Verbindungselement in einem nicht vorgeformten Ausgangszustand.
- Fig. 2: zeigt das Verbindungselement gemäß Fig. 1 in einem ersten vorgeformten Endzustand.
- Fig. 3: zeigt das Verbindungselement gemäß Fig. 1 in einem teilweise vorgeformten Zwischenzustand.
- Fig. 4: zeigt das Verbindungselement gemäß Fig. 1 in einem zweiten vorgeformten Endzustand, welcher aus dem in Fig. 3 gezeigten Zwischenzustand hervorgegangen ist.
- Fig. 5: ist eine teilweise aufgeschnittene Darstellung eines optoelektronischen Sensors, in dessen Gehäuse ein vorgeformtes erfindungsgemäßes Verbindungselement eingesetzt ist.

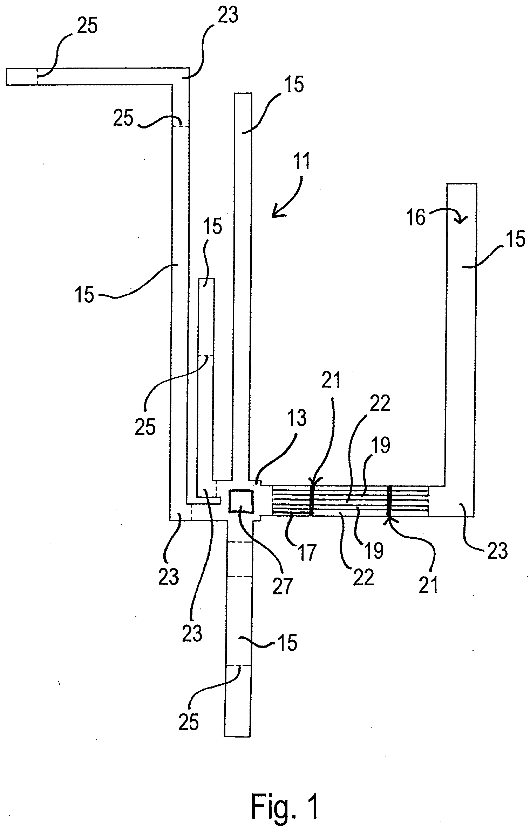

Fig. 1 zeigt einen flächigen Leitungskörper 11 aus Blech, welcher als Stanzteil ausgeführt ist und einen im Wesentlichen rechteckigen Zentralabschnitt 13 umfasst, von welchem aus sich hier insgesamt fünf streifenförmige Leitungsarme 15 in unterschiedliche Richtungen erstrecken. Auf die in Fig. 1 sichtbare Oberseite 16 des Leitungskörpers 11 ist eine nicht dargestellte, elektrisch isolierende Beschichtung aufgebracht. Auf diese Beschichtung sind wiederum Leiterbahnen aufgebracht, welche sich über alle Leitungsarme 15 erstrecken, wie es bei 17 am Beispiel des vom Zentralabschnitt 13 nach rechts weisenden Leitungsarms 15 angedeutet ist. Die einzelnen Leiterbahnen 17 eines Leitungsarms 15 sind dabei durch ausgestanzte Zwischenräume 19 voneinander getrennt. Zur Stabilisierung der durch die Zwischenräume 19 getrennten Einzelstreifen 22 eines Leitungsarms 15 sind Abstandhalter 21 aus Kunststoff in regelmäßigen Abständen in die Zwischenräume 19 eingegossen. Zur besseren Übersichtlichkeit sind in Fig. 1 die durch Zwischenräume 19 getrennten Einzelstreifen 22 einschließlich der Abstandhalter 21 lediglich in einem Abschnitt des vom Zentralabschnitt 13 nach rechts weisenden Leitungsarms 15 dargestellt. Bevorzugt erstreckt sich die Unterteilung über den gesamten Leitungsarm 15 bzw. über alle Leitungsarme 15. Ebenso versteht es sich, dass sich die lediglich abschnittsweise dargestellte Leiterbahn 17 vollständig über den betreffenden Einzelstreifen 22 erstreckt und dass jeder Einzelstreifen 22 in der Regel mit einer jeweiligen Leiterbahn 17 versehen ist.

Wie in Fig. 1 erkennbar ist, weisen hier drei der fünf Leitungsarme 15 eine oder zwei Abwinklungen 23 auf. Weiterhin sind mehrere Soll-Knickstellen bzw. Trennstellen durch Markierungen 25 in Form gestrichelter Linien kenntlich gemacht.

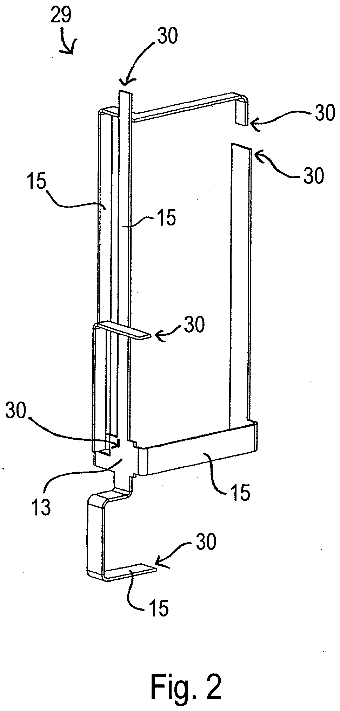

Der in Fig. 1 dargestellte flächige Leitungskörper 11 kann auf unterschiedliche Weise zu einem elektrischen Verbindungselement vorgeformt werden, wie nachstehend unter Bezugnahme auf Fig. 2 bis 4 näher ausgeführt wird. Konkret werden zum Vorformen einige oder alle streifenförmigen Leitungsarme 15 an einer oder mehreren Stellen entlang der Markierungen 25 geknickt und erforderlichenfalls durch Abschneiden auf eine gewünschte Länge gestutzt.

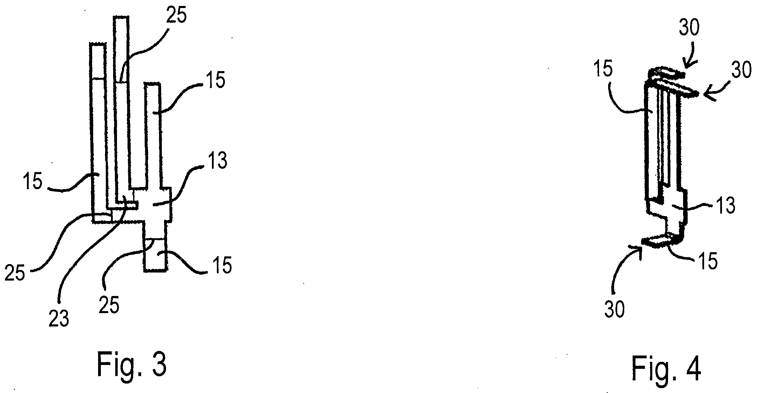

Beispielhaft zeigt Fig. 2 einen ersten Endzustand, zu dem der flächige Leitungskörper 11 gemäß Fig. 1 vorgeformt werden kann. Demgegenüber zeigt Fig. 4 einen alternativen zweiten Endzustand, zu welchem der flächige Leitungskörper 11 gemäß Fig. 1 vorgeformt werden kann. Dieser zweite Endzustand ist aus einem in Fig. 3 gezeigten Zwischenzustand hervorgegangen, in welchem die Leitungsarme 15 gestutzt, aber noch nicht geknickt sind.

Es versteht sich, dass eine Vielzahl weiterer Formvarianten ausgehend von ein und demselben flächigen Leitungskörper 11 erstellt werden können.

An dem Zentralabschnitt 13 kann schließlich ein Mikrochip 27 (Fig. 1) vorgesehen sein, welcher mit den Leiterbahnen 17 aller Leitungsarme 15 in elektrischem Kontakt steht. Dieser Mikrochip 27 kann z.B. eine speicherprogrammierbare Steuerung (SPS), eine anwendungsspezifische integrierte Schaltung (ASIC) und/oder einen Mikroprozessor enthalten und bildet z.B. eine zentrale Steuereinrichtung für einen optoelektronischen Sensor.

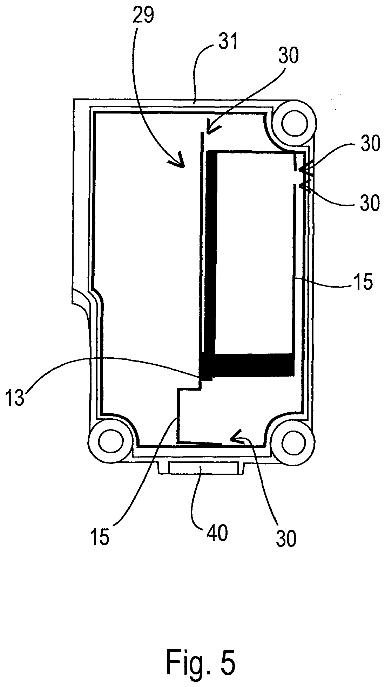

Bei der Herstellung eines optoelektronischen Sensors sind im Allgemeinen mehrere optoelektronische Komponenten wie Sender, Empfänger, Betätigungsknöpfe, und Anzeigeleuchten mit einer in dem zugehörigen Sensorgehäuse unterzubringenden Steuereinrichtung zu verbinden. Dies erfolgt erfindungsgemäß mittels eines Verbindungselements 29, wie nachfolgend unter Bezugnahme auf Fig. 5 näher ausgeführt wird. Zunächst wird ein Gehäuse 31 für den Sensor bereitgestellt, in welchem die entsprechenden Komponenten (nicht dargestellt) angebracht werden. Das vorgeformte Verbindungselement 29 wird dann wie in Fig. 5 dargestellt in das Gehäuse 31 eingesetzt und, gegebenenfalls unter leichtem Verbiegen der Leitungsarme 15, an die entsprechenden Komponenten angeschlossen, indem zum Beispiel die Enden der Leitungsarme 15, welche entsprechende Kontaktstellen 30 tragen, in die Komponenten eingesteckt oder die entsprechenden Leiterbahnen 17 an entsprechenden Kontakten der Komponenten angelötet werden. Die aufgrund der Unterteilung der Leitungsarme 15 in Einzelstreifen 22 vorhandene Flexibilität des Verbindungselements 29 erleichtert hierbei das Kontaktieren. Es müssen selbstverständlich nur diejenigen Leiterbahnen 17 auf dem vorgeformten Verbindungselement 29 verwendet werden, die zum Kontaktieren der jeweiligen, aktuell eingesetzten Komponenten benötigt werden. Andere Leiterbahnen 17 können unbenutzt bleiben.

Alle Komponenten sind dann über die entsprechenden Leiterbahnen 17 der Leitungsarme 15 mit dem zentralen Mikrochip 27 verbunden, so dass der optoelektronische Sensor im Prinzip betriebsbereit ist. Wie aus Fig. 5 hervorgeht, dient der untere Leitungsarm 15 der Anbindung des Sensors an eine Ausleseleitung sowie gegebenenfalls eine Stromversorgungsleitung über beziehungsweise durch einen nach außen führenden Anschluss 40.

Für den Fall, dass ein alternatives Sensorgehäuse, welches z.B. kleiner als das in Fig. 5 dargestellte Gehäuse 31 ist, mit einem elektrischen Verbindungselement zu bestücken ist, wird ein flächiger Leitungskörper 11 wie in Fig. 1 dargestellt, in einen alternativen Endzustand (beispielsweise wie in Fig. 4 gezeigt) vorgeformt.

Da zum Vorformen lediglich einfache Prozesse wie Abkanten, Biegen oder Abschneiden erforderlich sind, können die Herstellungskosten beim Fertigen unterschiedlicher Sensoren gering gehalten werden. Ein besonderer Vorteil der Erfindung ist darin zu sehen, dass der Grundkörper eines elektrischen Verbindungselements 29 als einfaches Stanzteil aus Blech ausgeführt ist, welches wesentlich kostengünstiger zu fertigen ist als beispielsweise eine individuelle Leiterplatte oder eine Anordnung von Flexkabeln.

### Bezugszeichenliste

- 11: Leitungskörper
- 13: Zentralabschnitt
- 15: Leitungsarm
- 16: Oberseite
- 17: Leiterbahn
- 19: Zwischenraum
- 21: Abstandhalter
- 22: Einzelstreifen
- 23: Abwinklung
- 25: Markierung
- 27: Mikrochip
- 29: Verbindungselement
- 30: Kontaktstelle
- 31: Gehäuse
- 40: Anschluss

## Patentansprüche

1. Elektrisches Verbindungselement (29) zum Verbinden von Komponenten eines optoelektronischen Sensors, mit einem flächigen Leitungskörper (11), welcher wenigstens einen streifenförmigen Leitungsarm (15) aufweist, wobei der streifenförmige Leitungsarm (15) eine elektrisch isolierende Beschichtung aufweist, auf welcher wenigstens eine sich zwischen zwei Kontaktstellen (30) erstreckende Leiterbahn (17) aufgebracht ist, wobei der Leitungskörper (11) aus Blech gefertigt ist und die Leiterbahn (17) durch die elektrisch isolierende Beschichtung elektrisch von dem streifenförmigen Leitungsarm (15) getrennt ist,
**dadurch gekennzeichnet, dass**
der wenigstens eine streifenförmige Leitungsarm (15) in mehrere durch Zwischenräume (19) voneinander getrennte, insbesondere parallel verlaufende Einzelstreifen (22) unterteilt ist, wobei auf jedem Einzelstreifen (22) eine Leiterbahn (17) aufgebracht ist, und wobei die Einzelstreifen (22) an wenigstens einer Stützstelle durch Abstandhalter (21) zusammengehalten sind.

2. Verbindungselement nach Anspruch 1,
**dadurch gekennzeichnet, dass**
der Leitungskörper (11) als Stanzteil ausgebildet ist.

3. Verbindungselement nach Anspruch 1 oder 2,
**dadurch gekennzeichnet dass**
die Einzelstreifen (22) an mehreren Stützstellen durch Abstandhalter (21) zusammengehalten sind.

4. Verbindungselement nach zumindest einem der vorstehenden Ansprüche,
**dadurch gekennzeichnet, dass**
der wenigstens eine streifenförmige Leitungsarm (15) wenigstens eine Abwinklung (23) und/oder wenigstens eine Soll-Knickstelle aufweist.

5. Verbindungselement nach zumindest einem der vorstehenden Ansprüche,
**dadurch gekennzeichnet, dass**
an dem wenigstens einen streifenförmigen Leitungsarm (15) wenigstens eine Markierung (25) vorgesehen ist, welche eine Soll-Knickstelle und/oder eine Trennstelle des Leitungsarms (15) kenntlich macht.

6. Verbindungselement nach zumindest einem der vorstehenden Ansprüche,
**dadurch gekennzeichnet, dass**
der Leitungskörper (11) einen Zentralabschnitt (13) umfasst, von welchem aus sich wenigstens zwei und bevorzugt wenigstens vier streifenförmige Leitungsarme (15) erstrecken.

7. Verbindungselement nach Anspruch 6,
**dadurch gekennzeichnet dass**
sich die wenigstens zwei Leitungsarme (15) ausgehend von dem Zentralabschnitt (13) in unterschiedliche Richtungen erstrecken.

8. Verbindungselement nach Anspruch 6 oder 7,
**dadurch gekennzeichnet, dass**
an dem Zentralabschnitt (13) ein Mikrochip (27) angeordnet ist, welcher mit den Leiterbahnen (17) aller Leitungsarme (15) in elektrischem Kontakt steht.

9. Optoelektronischer Sensor mit
einem Gehäuse (31) und mehreren in dem Gehäuse (31) untergebrachten Komponenten, wie Sender, Empfänger und Betätigungsknopf, wobei die Komponenten durch ein Verbindungselement (29) gemäß einem der vorstehenden Ansprüche elektrisch miteinander verbunden sind.

10. Verfahren zum Herstellen eines optoelektronischen Sensors, mit den Schritten:
- Bereitstellen eines Gehäuses (31) für den Sensor, und
- Anbringen mehrerer Komponenten wie Sender, Empfänger und Betätigungsknopf, in dem Gehäuse (31),
**gekennzeichnet durch** die weiteren Schritte:
- Bereitstellen eines Verbindungselements (29) nach einem der Ansprüche 1 bis 8,
- Vorformen des Verbindungselements (29) in Abhängigkeit von der Form und der Größe des Gehäuses (31) sowie von der Lage der Komponenten in dem Gehäuse (31) durch Knicken und/oder Durchtrennen des wenigstens einen streifenförmigen Leitungsarms (15), und
- Verbinden der Komponenten mittels des vorgeformten Verbindungselements (29).

## Claims

1. An electrical connection element (29) for connecting components of an optoelectronic sensor, having an areal conductor body (11) which has at least one strip-shaped conductor arm (15), wherein the strip-shaped conductor arm (15) has an electrically insulating coating to which at least one conductor track (17) is applied which extends between two contact points (30), with the conductor body (11) being produced from sheet metal and the conductor track (17) being electrically separated from the strip-shaped conductor arm (15) by the electrically insulating coating,
**characterized in that**
the at least one strip-shaped conductor arm (15) is divided into a plurality of individual strips (22) which are separated from one another by intermediate spaces (19) and which in particular extend in parallel, with a conductor track (17) being applied to each individual strip (22), and with the individual strips (22) being held together by spacers (21) at at least one support point.

2. A connection element in accordance with claim 1,
**characterized in that**
the conductor body (11) is configured as a stamped part.

3. A connection element in accordance with claim 1 or claim 2,
**characterized in that**
the individual strips (22) are held together by spacers (21) at a plurality of support points.

4. A connection element in accordance with at least one of the preceding claims,
**characterized in that**
the at least one strip-shaped conductor arm (15) has at least one angled portion (23) and/or at least one desired kink point.

5. A connection element in accordance with at least one of the preceding claims,
**characterized in that**
at least one marking (25) is provided at the at least one strip-shaped conductor arm (15) and identifies a desired kink point and/or a separation point of the conductor arm (15).

6. A connection element in accordance with at least one of the preceding claims,
**characterized in that**
the conductor body (11) comprises a central section (13) from which at least two strip-shaped conductor arms and preferably at least four strip-shaped conductor arms (15) extend.

7. A connection element in accordance with claim 6,
**characterized in that**
the at least two conductor arms (15) extend in different directions starting from the central section (13).

8. A connection element in accordance with claim 6 or claim 7,
**characterized in that**
a microchip (27) is arranged at the central section (13) and is in electrical contact with the conductor tracks (17) of all the conductor arms (15).

9. An optoelectronic sensor comprising
a housing (31) and a plurality of components accommodated in the housing (31) such as a transmitter, a receiver and an actuation button, with the components being electrically connected to one another by a connection element (29) in accordance with any one of the preceding claims.

10. A method of manufacturing an optoelectronic sensor comprising the steps:
- providing a housing (31) for the sensor; and
- attaching a plurality of components such as a transmitter, a receiver and an actuation button in the housing (31),
**characterized by** the further steps:
- providing a connection element (29) in accordance with any one of the claims 1 to 8;
- preshaping the connection element (29) in dependence on the shape and size of the housing (31) and on the position of the components in the housing (31) by kinking and/or cutting through the at least one strip-shaped conductor arm (15); and
- connecting the components by means of the preshaped connection element (29).

## Revendications

1. Élément de connexion électrique (29) pour connecter des composants d'un détecteur optoélectronique, comportant un corps conducteur surfacique (11) qui comprend au moins un bras conducteur (15) en forme de ruban, le bras conducteur (15) en forme de ruban présentant un revêtement électriquement isolant sur lequel est déposée au moins une piste conductrice (17) qui s'étend entre deux emplacements de contact (30), le corps conducteur (11) étant fabriqué en tôle et la piste conductrice (17) étant séparée électriquement du bras conducteur (15) en forme de ruban par le revêtement électriquement isolant,
**caractérisé en ce que**
ledit au moins un bras conducteur (15) en forme de ruban est subdivisé en plusieurs rubans individuels (22) séparés entre eux par des intervalles (19) et s'étendant en particulier parallèlement, une piste conductrice (17) étant déposée sur chaque ruban individuel (22) et les rubans individuels (22) étant maintenus ensemble par des éléments écarteurs (21) à au moins un emplacement de support.

2. Élément de connexion selon la revendication 1,
**caractérisé en ce que** le corps conducteur (11) est réalisé sous forme de pièce poinçonnée.

3. Élément de connexion selon la revendication 1 ou 2,
**caractérisé en ce que**
les rubans individuels (22) sont maintenus ensemble par des éléments écarteurs (21) à plusieurs emplacements de support.

4. Élément de connexion selon l'une au moins des revendications précédentes,
**caractérisé en ce que**
ledit au moins un bras conducteur (15) en forme de ruban présente au moins un coudage (23) et/ou au moins un emplacement destiné au pliage.

5. Élément de connexion selon l'une au moins des revendications précédentes,
**caractérisé en ce que**
sur ledit au moins un bras conducteur (15) en forme de ruban, il est prévu au moins un marquage (25) qui identifie un emplacement destiné au pliage et/ou un emplacement de séparation du bras conducteur (15).

6. Élément de connexion selon l'une des revendications précédentes,
**caractérisé en ce que**
le corps conducteur (11) comprend une portion centrale (13) à partir de laquelle s'étendent au moins deux et de préférence au moins quatre bras conducteurs en forme de ruban (15).

7. Élément de connexion selon la revendication 6,
**caractérisé en ce que**
lesdits au moins deux bras conducteurs (15) s'étendent à partir de la portion centrale (13) dans différentes directions.

8. Élément de liaison selon la revendication 6 ou 7,
**caractérisé en ce que** sur la portion centrale (13) est agencée une micro-puce (27) qui est en contact électrique avec les pistes conductrices (17) de tous les bras conducteurs (15).

9. Détecteur optoélectronique comportant
un boîtier (31) et plusieurs composants logés dans le boîtier (31), tels qu'un émetteur, un récepteur et un bouton d'actionnement, les composants étant connectés électriquement par un élément de connexion (29) selon l'une des revendications précédentes.

10. Procédé de réalisation d'un détecteur optoélectronique, comprenant les étapes suivantes :
- on fournit un boîtier (31) pour le détecteur, et
- on monte plusieurs composants, tels qu'un émetteur, un récepteur et un bouton d'actionnement, dans le boîtier (31),
**caractérisé par** les autres étapes suivantes :
- on fournit un élément de connexion (29) selon l'une des revendications 1 à 8,
- on préforme l'élément de connexion (29) en fonction de la forme et de la taille du boîtier (31) ainsi que de la position des composants dans le boîtier (31) par pliage et/ou séparation dudit au moins un bras conducteur (15) en forme de ruban, et
- on connecte les composants au moyen de l'élément de connexion préformé (29).
